# EUROPEAN PATENT APPLICATION

(11) **EP 2 071 640 A1**
(43) Date of publication of application: **17.06.2009**
(21) Application number: 07425789.0
(22) Date of filing: 14.12.2007
(51) Int. Cl.: H01L 33/00, H01L 25/075

(54) **Lighting device**

(71) Applicant: Albore, Giovanni Luigi, 74100 Taranto (IT)
(72) Inventor: Albore, Giovanni Luigi, 74100 Taranto (IT)
(74) Representative: Germinario, Claudio

(57) **Abstract**

The present invention refers to a LED lighting device. In particular, it refers to a LED module, manufactured by installing side-emitting solid-state LED or LASER chips on a substrate, obtaining great advantages in terms of cost and versatility.
By directly placing the individual devices on a common substrate, in practice there can be obtained a single lighting member, actually comprised of a plurality of LEDs, and equipped with its own light-reflection means.

## Description

The present invention refers to a LED lighting device.

The term LED (Light Emitting Diode) denotes a solid-state semiconductor emitting photons when traversed by electric current.

For the purposes of the present invention, hereinafter we will continue to use the term LED, to denote a single side-emitting solid-state photoemitter. Of course, it is understood that, in an entirely equivalent manner, also side-emitting LASERs could find use in the present invention in replacement of LED diodes.

Unlike standard incandescent bulbs, LEDs emit very little heat, consume scanty energy with respect to the light they produce, have a substantially longer life (hundreds of thousands of hours) without degradation of their features.

A light emitting diode is comprised of various layers of semiconducting material. When the LED is directly polarized, a particularly thin layer, called active layer, generates light.

Unlike what occurs in incandescent bulbs irradiating a continuous spectrum, a LED emits a practically monochromatic light of a specific colour that depends on the material used.

A white LED is actually a blue-light LED covered by a coating of special phosphorescent substance. Blue emission excites phosphor molecules, and the result is a white light, analogously to what occurs in fluorescent tubes in which UV produced by the ionized gas excites the layer of fluorescent substance on tube walls.

In invention of the complex blue-light LED system to obtain white light is due to the Japanese Shuji Nakamura.

Together with red and green LEDs, blue LEDs allow to manufacture RGB systems capable of reproducing all colours by additive synthesis, as occurring in a TV set/monitor.

Currently, the typical size of a LED is of a few hundreds of microns. With small emitters the opening widens, and it will be necessary to have side reflectors also vertically.

Each individual semiconducting diode is then mounted in a THT (Through-Hole Technology) SMT (Surface-Mount Technology) package, in which the electrical connection is made. The packaging, above all in the "THT" case, also protects the chip from the surrounding environment.

LEDs luminosity, homogeneity and colour rendering have been improved to such an extent that to date LED modules are beginning to be ever more widely used for room and area lighting.

LED modules are comprised of a given number of light emitting diodes mounted on a printed circuit with active or passive current-regulating devices. Depending on the application field it is also possible to add optics or light guides. Printed circuits can be rigid or flexible. Modules having a flexible printed circuit allow three-dimensional arrangements. The variety of colours, compactness and flexibility of the modules ensure wide creative options in the different applications. LED modules light up paths and contours, generate colour effects and ensure a higher safety in road signs.

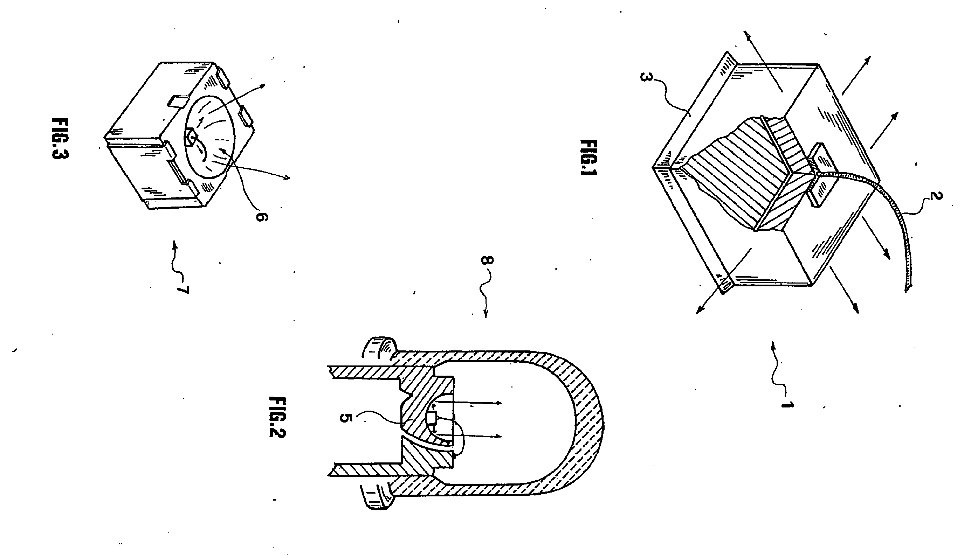

However, to date, the manufacturing of complex LED (modules or whatever) lighting devices is constrained by the use of a plurality of individual LED members. Currently, these members are individually welded inside of a sort of reflecting parabola (see Figures 2 and 3) and subsequently connected to the electric terminals and incorporated into a capsule (upon optional addition of phosphorescent material to modify the colour). Then, they are installed individually on a printed circuit containing in-series/in parallel connection tracks and peripheral circuits. Evidently, such a construction is scarcely flexible and efficient, and certainly it does not yet allow to best exploit LEDs potentials. Moreover, a less than perfect centering of the LEDs worsens the solid angle of emission and the use of a paraboloid becomes necessary to attempt to bring the side emission back to a substantially front emission, however without possibility of collimation.

Moreover, the light emitted by such an assembly of LEDs should necessarily be controlled through lenses (concentrating or other, depending on needs) or the like, to obtain overall the desired result.

Evidently, this entails a high manufacturing complexity and therefore high costs.

These drawbacks still make it difficult to use LEDs in order to totally replace traditional bulbs in a number of applications.

Hence, object of the present invention is to solve said problems, by providing a lighting device as defined in independent claim 1.

Secondary features of the present invention are defined in the corresponding dependent claims thereof.

The present invention, by overcoming the mentioned problems of the known art, entails several evident advantages.

Great advantages in terms of cost and versatility can be obtained by installing side-emitting solid-state LED or LASER chips on a substrate.

By directly placing the individual devices on a common substrate, in practice there can be obtained a single lighting member, actually comprised of a plurality of LEDs, and equipped with its own light-reflection means.

Therefore, by suitably shaping the support and the reflection means, and arranging the LEDs according to specifically designed geometries, it is obtained a device exhibiting an extremely high efficiency, which can effectively replace a traditional bulb.

Moreover, the same technology allows to manufacture an additional variety of devices, not only for lighting but also, e.g., displays or other, as it will be better explained below.

Further advantages, as well as features and the operation modes of the present invention, will be made evident from the following detailed description of preferred embodiments thereof, given by way of example and not for limitative purposes. Reference will be made to the figures of the annexed drawings, wherein:
- Figure 1 shows a semiconductor LED device;
- Figure 2 is a view of a LED in an SMT-type package;
- Figure 3 is a view of a LED in a THT-type package;
- Figures 4A and 4B shows known multi-LED lamps;
- Figure 5 shows a portion of a LED module according to the present invention;
- Figure 6 is a sectional view of a LED module led according to the present invention;
- Figures 7A and 7B show two possible modes for the electrical connection of the semiconductor devices on a substrate; and
- Figures 8A and 8B show two possible embodiments of a LED module according to the present invention for different applications.

The present invention will hereinafter be detailed making reference to the above-indicated figures.

Referring initially to Figure 1, it shows a semiconductor LED device 1. In practice, it is a diode manufactured so as to emit, when electrically excited, a luminous radiation along its side walls, transversal with respect to the junction. The electrical connections are usually obtained on the bottom and top walls, parallel to the junction. In particular, one of the two connections can occur by contact with a conductive substrate 3, and the other one by means of a connecting wire 2 welded onto the top wall.

In order to make a useful luminous beam, the diode is mounted into a reflecting support 5, 6, of substantially parabolic shape. Such a support may be housed an SMT-type package 7, for surface mounting, or a THT-type package 8, to manufacture the common LEDs used for the most varied applications.

In both cases, the device has to be protected through an external casing, usually made of plastics. The external casing is not for determining the colour of the emission, which is determined by the type of semiconductor, but may be for determining the diffusion modes thereof.

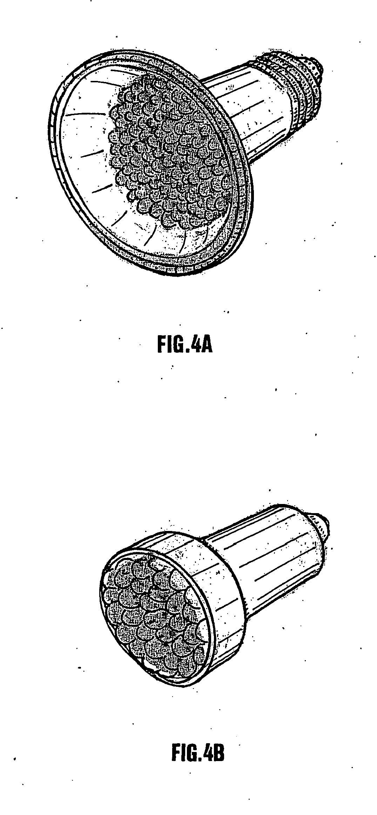

Therefore, to date for the manufacturing of multi-LED lamps (see Figures 4A and 4B) or of LED modules for the manufacturing of panels of various types, it is necessary to mount onto a support a plurality of individual LEDs, each encapsulated independently of the other ones.

Moreover, in order to optionally obtain a specific diffusion of the light, e.g. a more or less concentrated beam, it is necessary to use additional corrective lenses.

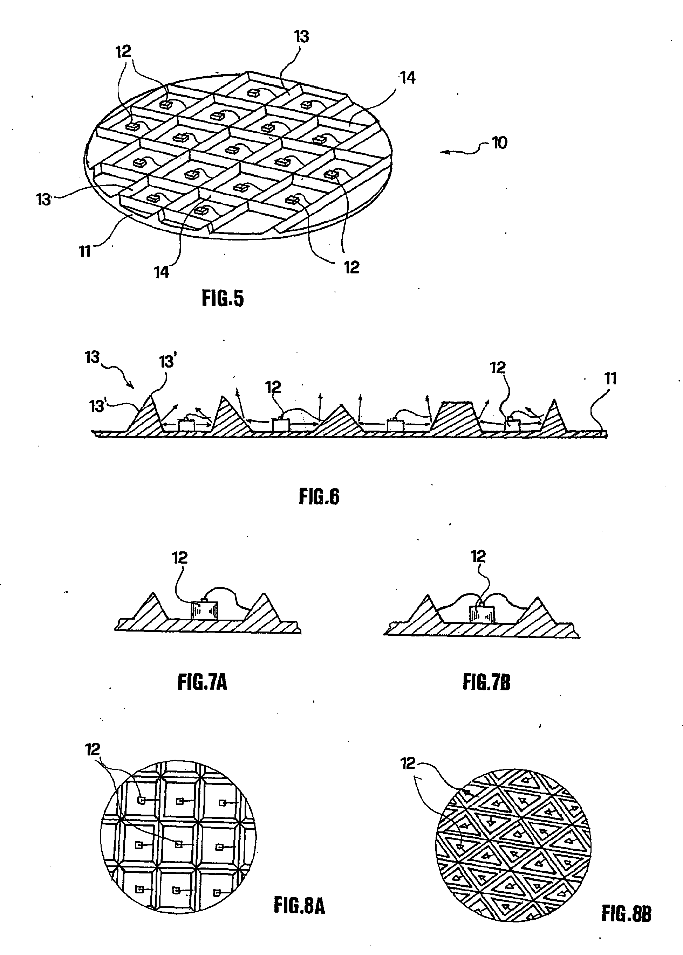

Referring now to Figure 5, it shows a portion of a LED module 10 according to the present invention.

The LED module 10 comprises a substrate 11, on which it is mounted a plurality of semiconductor LED devices 12, according to a preset arrangement.

In the example of Figure 5 the semiconductor LED devices 12 are arranged by parallel rows and columns, at the vertexes of respective squares.

Between each row and each column of semiconductor LED devices 12, there are provided respective prismoidal devices 13, 14 for the reflection and/or diffusion of the luminous emission. In particular, each of these reflection devices 13, 14 constitutes a separation member between two adjacent rows or columns and has respective faces 13', 14', reflecting and tilted with respect to the substrate plane.

Figure 6, which is a sectional view of a LED module according to the present invention, better clarifies the embodiment and the function of the reflection devices 13, 14.

As mentioned hereto, the LED devices 12 are side-emitting devices, as indicated by arrows in Figure 6.

Light emitted by each device 12 reaches walls 13', 14' of the reflection members 13, 14 surrounding it.

Walls 13', 14' being reflecting, the luminous emission will be reflected depending on the tilt of the walls 13', 14' with respect to the substrate plane. In general, light will be reflected in a direction more or less orthogonal with respect to the substrate plane itself.

This allows, by specifically designing the tilt of the walls of the reflection members 13, 14, to obtain a light beam generally emitted by the plurality of LEDs 12, diffused and oriented in any desired way.

In particular, it is possible to define the solid angle of emission or polar diagram of the beam also within the scope of a same module, merely by using different tilts for the different reflection members. Figure 6 shows, by way of example, how a different tilt of the walls can generate a different beam of light.

Figures 7A and 7B illustrate, purely by way of example, two options offered for the electrical connection of the LED devices 12. In fact, the latter may be connected in series and/or in parallel according to needs, through electrical connections obtained in the (e.g., conductive) substrate. Advantageously, the walls 13', 14' may be coated with a conductive (e.g., metallic) material, and be them also exploited as electrical conductors, other than as reflecting surfaces.

Figure 7B shows such an example. Of course, wire connections may be replaced by elastic conducting blades resting just on the device, in a manner such as to avoid even the welding.

The entire LED module 10 can then be protected in a single package having a single pair of power-supplying terminals.

Installing the semiconductor devices onto the substrate, currently based on welding, could be replaced by glueing onto the ceramics-metallic surface or bonding onto a plastics-silicone substrate. With silicone substrates there can be obtained large and foldable panels.

By varying the density of the LEDs, there could be had various types of lamps and panels entitled for emission and power-supply voltage. A control voltage or frequency could regulate the analog modulators.

By means of a digital data transfer system it will be possible to indicate a failure to the central computer, or to define the luminous emission therefrom.

By installing blue and yellow LEDs it is obtained an improved effectiveness of yellow phosphor (which absorbs blue radiation) and it is allowed the varying of the colour temperature at will.

By optional additions of small quantities of red and green LEDs, white is made visually nicer.

Laser use will further increase the efficiency of these lamps and, in the initial phase, by adding LEDs or phosphors there may be avoided the annoying interference fringes of coherent light, whereas in a subsequent phase there could be obtained multiple-ray lasers of different colour preceded by coherence-free multiple-ray components.

Of course, it is understood that shape, size, structure, rigidity, etc. of the module according to the present invention are features that could be freely varied depending on the different applications, without varying the inventive concept thereof.

Lastly, for the manufacturing of modules and lamps according to the present invention, of remarkable power (nautical beacons, spotlights, etc) it will be possible to cool the lamp with a fluid.

A LED module according to the present invention is advantageous for an infinite number of possible applications. Hereinafter a description of some of them will be provided, it being understood that these examples are not to be construed as limitative and that the LED module according to the present invention could be used in other applications.

### APPLICATION EXAMPLES

### Reading lamp

By installing the semiconductor devices on a substrate (separation among chips could be much lower than one tenth of millimetre) and tilting the reflecting walls of an angle ranging from 45 and 60° a strong central emission will be had, with a cylindrical, paraspherical or paraellipsoidal lateral one having a not very wide opening, capable of illuminating very well the text at the emission centre; by yielding a low side lighting, it allows anyhow to see the area nearby a book.

### Dentist lamp, clockmaker lamp or the like

By setting at 45° (45.5° max) the walls of the reflection members, there will be obtained a well-collimated ray toward the mouth (or the item being worked), capable of letting the technician work with a suitable lighting at a very small fraction of the electric power absorbed by current lamps (of a power such as to need a fan for dispersing produced heat).

### Vehicle lights

By defining a variable angle of the reflecting surfaces, we could form the emitted ray in order to obtain the desired shape, in which the main emission is cylindrical with a widening at one side, as envisaged by rules of the field.

The design may be a single one for all motor cars and it will need a design work performed only once and amortized by the immense number of models produced.

The great emission required is easily achievable by positioning a great number of LED devices on the substrate; this helps to have a very uniform emission, absorbing a trifling power.

### Ceiling lamps, luminous walls and LCD backlighting

In this case the substrate could be of remarkable dimensions and the LEDs could be relatively spaced therebetween and separated by a scattering material of controlled (constant or variable) nebulosity so as to uniform the emission with the distance from the LED. In this case, human imagination is the only limit.

### LED TV sets and direct-vision and projection monitors

By producing panels with red, green and blue LEDs in triads it will be possible to produce TV sets and projection units with LEDs much brighter than those possible with OLED technology, but at costs sensibly lower and emission decidedly superior than tube- and LCD projectors.

In the case of projectors, reflecting walls should be at 45°; instead, in LED panels a certain diffusion is required, obtainable casewise with a designer-defined technique.

In order to obtain the best colours, it will be possible to add a LED adjustment electronics for LEDs (on 1024*768 pixels we will have 576 Mbytes of correction memory, something currently well feasible at a low cost).

By making triangular diodes, it is possible to make modules like that schematically depicted in Figure 8B, and miniaturize the RGB triads with a better visual yield, especially for projectors.

The present invention has hereto been described according to preferred embodiments thereof, given by way of example and not for limitative purposes.

It is understood that other embodiments might be envisaged, all to be construed as falling within the protective scope of the same, as defined by the appended claims.

## Claims

1. A lighting device, comprising:
- a support substrate (11);
- a plurality of side light-emitting semiconductor devices (12), not individually encapsulated, arranged on said substrate (11);
- a plurality of devices (13, 14) for reflecting the emitted light,
wherein each semiconductor device (12) is flanked, on at least one side thereof, by a corresponding reflection device (13, 14), said reflection device (13, 14) having at least one reflecting wall (13', 14'), tilted with respect to the normal of the substrate plane.

2. The lighting device according to claim 1, wherein said semiconductor devices (12) comprise at least one LED diode.

3. The lighting device according to claim 1 or 2, wherein said semiconductor devices (12) comprise at least one solid-state laser.

4. The lighting device according to one of the preceding claims, wherein said semiconductor devices (12) are arranged according to a regular lattice.

5. The lighting device according to claim 4, wherein said semiconductor devices (12) are arranged by rows and columns.

6. The device according to one of the preceding claims, wherein each reflection device (13, 14) is of substantially prismoidal shape and constitutes a separation member between at least two of said adjacent semiconductor devices (12).

7. The device according to one of the preceding claims, wherein said support substrate is of a conductive material, suitable for the power-supplying of said semiconductor devices (12).

8. The device according to one of the preceding claims, wherein said walls (13', 14') of said reflection devices (13, 14) are coated with a conductive material, suitable for the power-supplying of said semiconductor devices (12).

9. The lighting device according to claim 8, wherein each semiconductor device (12) is electrically connected to said walls (13', 14'), by means of a wire connection.

10. The lighting device according to claim 8, wherein each semiconductor device (12) is electrically connected to said walls (13', 14'), by means of one or more elastic metal blades.

11. The lighting device according to one of the claims 1 to 10, wherein each semiconductor device (12) is of parallelepiped shape and it is flanked, on the four sides thereof, by corresponding reflection devices (13, 14).

12. The lighting device according to one of the claims 1 to 10, wherein each semiconductor device (12) is of triangle-base prism shape and it is flanked on three sides thereof by corresponding reflection devices (13, 14).

13. The lighting device according to one of the preceding claims, wherein said support substrate (11) is made of flexible material.

14. The lighting device according to one of the preceding claims, wherein said semiconductor devices (12) are welded onto the support substrate (11).

15. The lighting device according to one of the claims 1 to 13, wherein said semiconductor devices (12) are glued by adhesive onto the support substrate (11).

16. The lighting device according to one of the preceding claims, integrally encapsulated.

17. The lighting device according to one of the preceding claims, wherein one or more of the semiconductor devices (12) is surrounded by a diffusion system having constant nebulosity.

18. The lighting device according to one of the preceding claims, wherein one or more of the semiconductor devices (12) is surrounded by a diffusion system having constant nebulosity.
